# EUROPEAN PATENT APPLICATION

(11) **EP 4 613 917 A1**
(43) Date of publication of application: **10.09.2025**
(21) Application number: 23885632.2
(22) Date of filing: 26.10.2023
(51) Int. Cl.: C30B 29/04, B23B 27/20, B28D 5/00, C30B 25/20

(54) **DIAMOND TOOL AND TOOL UNIT**

(30) Priority: 31.10.2022 JP 2022174819
(71) Applicant: Mitsuboshi Diamond Industrial Co., Ltd., Settsu, Osaka 566-0034 (JP); NATIONAL INSTITUTE OF ADVANCED INDUSTRIAL SCIENCE AND TECHNOLOGY, Tokyo 100-8921 (JP)
(72) Inventor: KITAICHI, Mitsuru, Settsu-city, Osaka 566-0034 (JP); TANAKA, Maki, Settsu-city, Osaka 566-0034 (JP); AKIYAMA, Yusuke, Settsu-city, Osaka 566-0034 (JP); OHMAGARI, Shinya, Tosu-shi, Saga 841-0052 (JP)
(74) Representative: TBK
(86) International application number: PCT/JP2023/038619
(87) International publication number: WO 2024/095876

(57) **Abstract**

A diamond tool (20) comprises: a base part (30) that contains a single crystal part (32) constituted of single crystal diamond; and a conductive part (40) formed on the single crystal part (32). The conductive part (40) contains a conductive part surface (41) that constitutes the surface of the diamond tool (20). The base part (30) is constituted of only the single crystal part (32) exhibiting electrical insulating behavior.

## Description

### TECHNICAL FIELD

The present invention relates to a diamond tool and a tool unit.

### BACKGROUND ART

Scribing wheels, diamond points, single point tools, drills, and endmills are examples of diamond tools. Patent Literature 1 describes an example of a scribing wheel formed from diamond.

### CITATION LIST

### Patent Literature

Patent Document 1: Japanese Laid-Open Patent Publication No. 2022-99809

### SUMMARY OF INVENTION

### Technical Problem

Cutting chips may collect on a diamond tool due to electrostatic attractive force. Cutting chips may be referred to as particles or cullets. The collection of cutting chips on a diamond tool may adversely affect, for example, the machining performance of the diamond tool.

### Solution to Problem

A diamond tool related to the present invention includes a base including a single-crystal portion formed by a single-crystal diamond, and a conductive portion formed on the single-crystal portion. The conductive portion includes a conductive portion surface forming a surface of the diamond tool, and the base is formed by only the single-crystal portion that is electrically insulating.

The diamond tool has, for example, the following advantage. The surface of the diamond tool defines a tool surface that has electrical conductivity and is thus resistant to electrical charging. This reduces the cutting chips that collect on the tool surface.

In one example of the diamond tool, the conductive portion surface includes hydrogen-terminated diamond.

The diamond tool has, for example, the following advantage. The conductive portion includes the hydrogen-terminated diamond. This increases the electrical conductivity of the conductive portion.

In one example of the diamond tool, the conductive portion includes a hydrogen-terminated layer and an impurity layer, the impurity layer is formed on the single-crystal portion, and the hydrogen-terminated layer is formed on the impurity layer and includes the hydrogen-terminated diamond.

The diamond tool has, for example, the following advantage. The conductive portion includes the hydrogen-terminated layer and the impurity layer. This increases the electrical conductivity of the conductive portion.

In one example of the diamond tool, the conductive portion surface forms an entirety of the surface of the diamond tool.

The diamond tool has, for example, the following advantage. The cutting chips that collect on the tool surface are reduced.

In one example of the diamond tool, the conductive portion has an electrical resistivity of 10 Ω cm or less.

The diamond tool has, for example, the following advantages. The conductive portion is resistant to electrical charging. The tool surface is resistant to electrical charging.

In one example of the diamond tool, the conductive portion has a thickness of 2000 nm or less.

The diamond tool has, for example, the following advantage. The difference is reduced between the shape of the surface of the base, prior to formation of the conductive portion, and the shape of the surface of the conductive portion.

In one example of the diamond tool, the diamond tool is a scribing wheel.

The diamond tool has, for example, the following advantage. When scribing a workpiece with the scribing wheel, the cutting chips that collect on the scribing wheel are reduced.

A tool unit related to the present invention includes the diamond tool and a tool support supporting the diamond tool.

The tool unit has, for example, the following advantages. The tool surface is resistant to electrical charging. The cutting chips that collect on the tool surface are reduced. The deposition of cutting chips is reduced between the diamond tool and the tool support.

### Advantageous Effects of Invention

The cutting chips that collect on the diamond tool and the tool support are reduced.

### BRIEF DESCRIPTION OF DRAWINGS

Fig. 1 is a schematic diagram of a tool unit.
Fig. 2 is a cross-sectional view of a diamond tool.
Fig. 3 is a block diagram of a diamond synthesis device.
Fig. 4 is a side view of a scribe head.
Fig. 5 is a front view of the scribe head.
Fig. 6 is a side view of a scribing wheel.
Fig. 7 is a cross-sectional view of the scribing wheel.
Fig. 8 is a cross-sectional view of a holder unit.

### DESCRIPTION OF EMBODIMENTS

### First Embodiment

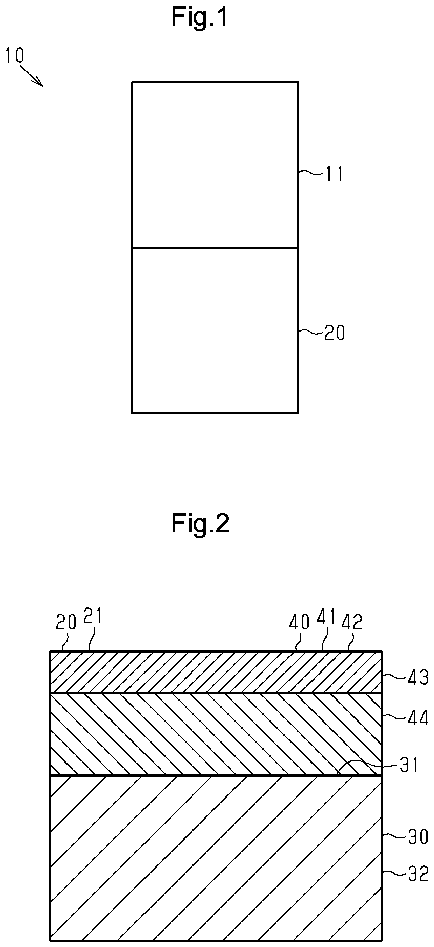

Reference will be made to Figs. 1 and 2. Fig. 1 is a schematic diagram of a tool unit 10. Fig. 2 is a schematic diagram showing the cross-sectional structure of a diamond tool 20. The tool unit 10 and the diamond tool 20 may have any structure. The tool unit 10 and the diamond tool 20 are not limited to the exemplified structures.

In one example, the tool unit 10 is incorporated in a machining device. In one example, the machining device is configured to perform predetermined machining on a workpiece. Examples of the machining device include a scriber, a lathe, a drilling machine, a boring machine, and a milling machine. In one example, the machining device includes a machining device body, the tool unit 10, and the like.

In one example, the tool unit 10 includes a tool support 11 and the diamond tool 20. In one example, the tool support 11 is configured to be coupled to the machining device body. In one example, the tool support 11 is configured to support the diamond tool 20.

In one example, the diamond tool 20 is configured to be applied to ultra-precision machining, precision machining, or general machining. In one example, the diamond tool 20 is configured to include single-crystal diamond.

Scribing wheels, diamond points, single point tools, drills, and endmills are examples of the diamond tool 20. The surface of the diamond tool 20 is referred to as "the tool surface 21."

In one example, the diamond tool 20 includes a base 30. In one example, the base 30 forms the main body of the diamond tool 20. The surface of the base 30 is referred to as "the base surface 31."

In one example, the base 30 is configured to include single-crystal diamond. In one example, the base 30 includes a single-crystal portion 32 formed from single-crystal diamond. In one example, the single-crystal portion 32 is electrically insulating. The structure of the single-crystal portion 32 will now be described.

In a first example, the single-crystal portion 32 forms an entirety of the base 30. The base surface 31 is entirely formed by the single-crystal portion 32.

In a second example, the single-crystal portion 32 forms a part of the base 30. The entire base surface 31 is formed by the single-crystal portion 32.

In a third example, the single-crystal portion 32 forms a part of the base 30. A part of the base surface 31 is formed by the single-crystal portion 32. Other parts of the base surface 31 is formed by a material other than single-crystal diamond.

In one example, the diamond tool 20 includes a conductive portion 40 having electrical conductivity. In one example, the conductive portion 40 is a thin film including an electrically conductive diamond.

In one example, the conductive portion 40 is configured to impart electrical conductivity to the diamond tool 20. In one example, the conductive portion 40 is configured to impart electrical conductivity to a part of or an entirety of the tool surface 21.

In one example, the conductive portion 40 is formed on the base 30. In one example, the conductive portion 40 is formed on the base surface 31 of the single-crystal portion 32.

In one example, the base surface 31 includes at least one of a base plane, an inclined surface, and a curved surface. In one example, the base plane is a plane parallel to the center line or center plane of the diamond tool 20. In one example, the inclined surface is a surface inclined to the base plane.

In one example, the conductive portion 40 is formed on the base surface 31, which is at least one of the base surface 31 that is a base plane, the base surface 31 that is an inclined surface, and the base surface 31 that is a curved surface.

A state of the diamond tool 20 prior to formation of the conductive portion 40 on the base 30 and prior to formation of the diamond tool 20 with only the base 30 is referred to as "the base state."

In one example, the diamond tool 20 is configured to be provided with a machining performance suitable for machining a workpiece in the base state. In one example, the entire base surface 31 forming the tool surface 21 of the diamond tool 20 in the base state is formed by the single-crystal portion 32. In one example, the tool surface 21 of the diamond tool 20 in the base state does not have electrical conductivity.

The surface of the conductive portion 40 is referred to as "the conductive portion surface 41." The conductive portion surface 41 imparts electrical conductivity to the tool surface 21. In one example, the conductive portion surface 41 forms a part of or an entirety of the tool surface 21.

In one example, the conductive portion 40 includes hydrogen-terminated diamond 42. In one example, the hydrogen-terminated diamond 42 forms the conductive portion surface 41. In one example, the surface of the hydrogen-terminated diamond 42 is hydrogen-terminated. In one example, the hydrogen-terminated diamond 42 has electrical conductivity. In one example, the hydrogen-terminated diamond 42 is single-crystal diamond or polycrystalline diamond.

In one example, the conductive portion 40 includes one or more layers. Examples of layers forming the conductive portion 40 include a hydrogen-terminated layer 43 and an impurity layer 44. In one example, the conductive portion 40 includes at least one of the hydrogen-terminated layer 43 and the impurity layer 44.

Examples of structures related to the layers of the conductive portion 40 include first to third layer structures. In the first layer structure, the conductive portion 40 includes only the hydrogen-terminated layer 43. In the second layer structure, the conductive portion 40 includes only the impurity layer 44. In the third layer structure, the conductive portion 40 includes the hydrogen-terminated layer 43 and the impurity layer 44.

In the first layer structure, the hydrogen-terminated layer 43 is formed on the base surface 31. In the second layer structure and the third layer structure, the impurity layer 44 is formed on the base surface 31. In the third layer structure, the hydrogen-terminated layer 43 is formed on the surface of the impurity layer 44.

In one example, the hydrogen-terminated layer 43 is formed by the hydrogen-terminated diamond 42. In one example, the hydrogen-terminated layer 43 has electrical conductivity. In one example, the surface of the hydrogen-terminated layer 43 forms the conductive portion surface 41.

In one example, the impurity layer 44 is formed by single-crystal diamond including an impurity or polycrystalline diamond including an impurity. In one example, the impurity layer 44 has electrical conductivity. Examples of the impurity include boron, nitrogen, and phosphorus.

The conductive portion 40 has a thickness referred to as "the conductive portion thickness." The hydrogen-terminated layer 43 has a thickness referred to as "the hydrogen-terminated layer thickness." The thickness of the impurity layer 44 is referred to as "the impurity layer thickness." One example of a method for measuring the conductive portion thickness, the hydrogen-terminated layer thickness, and the impurity layer thickness is secondary ion mass spectrometry.

In one example, the conductive portion thickness affects the electrical conductivity of the conductive portion 40. In one example, the conductive portion thickness affects the shape of the conductive portion surface 41. In one example, the conductive portion thickness is within a predetermined conductive portion thickness range. Example of the predetermined conductive portion thickness range will now be described.

In a first example, the predetermined conductive portion thickness range is a range greater than or equal to a lower limit conductive portion thickness. In a second example, the predetermined conductive portion thickness range is a range less than or equal to an upper limit conductive portion thickness. In a third example, the predetermined conductive portion thickness range is a range greater than or equal to the lower limit conductive portion thickness and less than or equal to the upper limit conductive portion thickness.

In one example, the lower limit conductive portion thickness is selected from 1 nm, 2 nm, and 5 nm. In one example, the upper limit conductive portion thickness is selected from 200 nm, 500 nm, and 2000 nm.

In one example, the hydrogen-terminated layer thickness is less than the impurity layer thickness. In one example, the hydrogen-terminated layer thickness is within a predetermined hydrogen-terminated layer thickness range. Examples of the predetermined hydrogen-terminated layer thickness range will now be described.

In a first example, the predetermined hydrogen-terminated layer thickness range is a range greater than or equal to a lower limit hydrogen-terminated layer thickness. In a second example, the predetermined hydrogen-terminated layer thickness range is a range less than or equal to an upper limit hydrogen-terminated layer thickness. In a third example, the predetermined hydrogen-terminated layer thickness range is a range greater than or equal to the lower limit hydrogen-terminated layer thickness and less than or equal to the upper limit hydrogen-terminated layer thickness.

In one example, the lower limit hydrogen-terminated layer thickness is selected from 1 nm, 2 nm, and 5 nm. In one example, the upper limit hydrogen-terminated layer thickness is selected from 6 nm, 8 nm, and 10 nm.

In one example, the impurity layer thickness is greater than the hydrogen-terminated layer thickness. In one example, the impurity layer thickness is within a predetermined impurity layer thickness range. Examples of the predetermined impurity layer thickness range will now be described.

In a first example, the predetermined impurity layer thickness range is in a range greater than or equal to the lower limit impurity layer thickness. In a second example, the predetermined impurity layer thickness range is a range less than or equal to the upper limit impurity layer thickness. In a third example, the predetermined impurity layer thickness range is a range greater than or equal to the lower limit impurity layer thickness and less than or equal to the upper limit impurity layer thickness.

In one example, the lower limit impurity layer thickness is selected from 10 nm, 50 nm, and 100 nm. In one example, the upper limit impurity layer thickness is selected from 200 nm, 500 nm, and 2000 nm.

The impurity layer thickness is divided by the hydrogen-terminated layer thickness to obtain a value referred to as "the thickness layer ratio." In one example, the thickness layer ratio is within a predetermined thickness layer ratio range. Examples of the predetermined thickness layer ratio range will now be described.

In a first example, the predetermined thickness layer ratio is a range greater than or equal to the lower limit thickness layer ratio. In a second example, the predetermined thickness layer ratio is a range less than or equal to the upper limit thickness layer ratio. In a third example, the predetermined thickness layer ratio is a range greater than or equal to the lower limit thickness layer ratio and less than or equal to the upper limit thickness layer ratio.

In one example, the lower limit thickness layer ratio is selected from 0.005, 0.016, and 0.03. In one example, the upper limit thickness layer ratio is selected from 0.04, 0.05, and 0.1.

The conductive portion 40 has an electrical resistivity referred to as "the conductive portion resistivity." In one example, the conductive portion resistivity is an index related to the electrical conductivity of the conductive portion 40. In one example, the conductive portion resistivity is within a predetermined conductive portion resistivity range. Examples of the predetermined conductive portion resistivity range will now be described.

In a first example, the predetermined conductive portion resistivity range is a range greater than or equal to a lower limit conductive portion resistivity. In a second example, the predetermined conductive portion resistivity range is a range less than or equal to an upper limit conductive portion resistivity. In a third example, the predetermined conductive portion resistivity range is a range greater than or equal to the lower limit conductive portion resistivity and less than or equal to the upper limit conductive portion resistivity.

In one example, the lower limit conductive portion resistivity is selected from 1 mΩ cm, 10 mΩ cm, and 100 mΩ cm. In one example, the upper limit conductive portion resistivity is selected from 500 mΩ cm, 1 Ω cm, and 10 Ω cm.

### Manufacturing Device

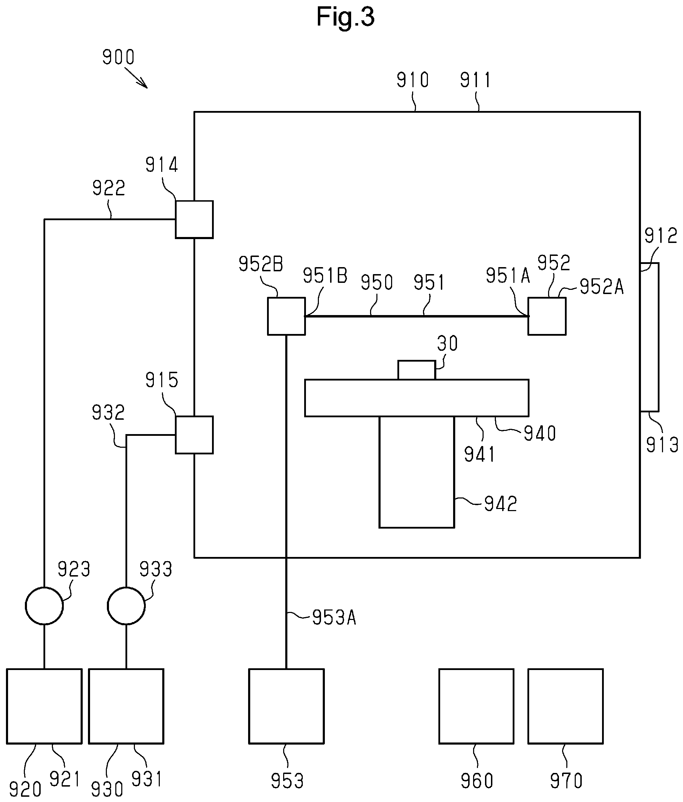

Reference will be made to Fig. 3. In one example, the conductive portion 40 is formed through a predetermined manufacturing method. Examples of the predetermined manufacturing method include hot-filament Chemical Vapor Deposition (CVD), microwave plasma CVD, and direct current plasma CVD. In one example, hot-filament CVD is selected as the predetermined manufacturing method.

In one example, hot-filament CVD uses a diamond synthesis device 900 to synthesize the conductive portion 40 on at least part of the base 30, which is the base material.

In one example, the diamond synthesis device 900 includes a vacuum chamber 910. In one example, the vacuum chamber 910 includes a synthesis compartment 911. In one example, the synthesis compartment 911 acts as a space for synthesizing diamond on the base material through a chemical reaction using raw material gas. In one example, the vacuum chamber 910 is configured to keep the synthesis compartment 911 vacuum.

In one example, the vacuum chamber 910 includes an open portion 912. In one example, the open portion 912 connects the synthesis compartment 911 with the space outside the vacuum chamber 910 (hereafter referred to as "the external space"). In one example, the open portion 912 is configured to allow the base material to be loaded into the synthesis compartment 911 and unloaded from the synthesis compartment 911.

In one example, the vacuum chamber 910 includes a shutter 913. In one example, the shutter 913 is configured to open and close the open portion 912. In one example, the shutter 913 is configured to select an open state or a closed state.

When the shutter 913 is in an open state, the open portion 912 is open. When the shutter 913 is in a closed state, the open portion 912 is closed.

In one example, the vacuum chamber 910 includes a discharge port 914. In one example, the discharge port 914 connects the synthesis compartment 911 and the external space.

In one example, the vacuum chamber 910 includes a supply port 915. In one example, the supply port 915 connects the synthesis compartment 911 and the external space.

In one example, the diamond synthesis device 900 includes a gas discharging portion 920. In one example, the gas discharging portion 920 discharges stagnant gas out of the synthesis compartment 911 to the external space. In one example, the gas discharging portion 920 includes a vacuum pump 921, a discharge pipe 922, and a discharge regulation valve 923.

In one example, the vacuum pump 921 draws in the stagnant gas from the synthesis compartment 911 and discharges the drawn-in gas to the external space. Examples of the vacuum pump 921 include a rotary pump, an oil diffusion pump, and a turbo-molecular pump.

In one example, the discharge pipe 922 connects the discharge port 914 of the vacuum chamber 910 and the vacuum pump 921. The stagnant gas in the synthesis compartment 911 flows through the discharge port 914 and the discharge pipe 922 and is drawn into the vacuum pump 921.

In one example, the discharge regulation valve 923 is arranged in the discharge pipe 922. In one example, the discharge regulation valve 923 is configured to regulate the flow rate of the gas flowing through the discharge pipe 922.

In one example, the diamond synthesis device 900 includes a gas supply unit 930. In one example, the gas supply unit 930 is configured to supply raw material gas to the synthesis compartment 911. In one example, the gas supply unit 930 includes a gas tank 931, a supply pump 932, and a supply regulation valve 933.

In one example, the gas tank 931 stores the raw material gas supplied to the synthesis compartment 911. In one example, the raw material gas includes a carbon source that contributes to diamond synthesis.

In one example, the raw material gas includes one or more types of carbon sources. One example of a carbon source is methane.

In one example, the raw material gas is a gas mixture in which a carbon source gas including the carbon source is mixed with a carrier gas. One example of a carrier gas is hydrogen gas.

In one example, the raw material gas further includes an impurity source doped in diamond. In one example, the raw material gas includes one or more impurity sources.

Examples of the impurity source include boron, a boron compound, and phosphorus. Examples of a boron compound include trimethylborane and diborane.

In one example, the supply pump 932 connects the supply port 915 of the vacuum chamber 910 and the gas tank 931. The raw material gas flows through the supply pump 932 and the supply port 915 and is supplied to the synthesis compartment 911.

In one example, the supply regulation valve 933 is arranged in the supply pump 932. In one example, the supply regulation valve 933 is configured to regulate the flow rate of the raw material gas flowing through the supply pump 932.

In one example, the diamond synthesis device 900 includes a platform 940. In one example, the platform 940 is a part configured to support the base material in the synthesis compartment 911.

In one example, the platform 940 includes a table 941. In one example, the table 941 is arranged in the synthesis compartment 911 in a manner movable relative to the vacuum chamber 910. In one example, the table 941 is configured to allow the base material to be arranged thereon.

In one example, the platform 940 includes a drive unit 942. In one example, the drive unit 942 is configured to move the table 941 relative to the vacuum chamber 910. In one example, the drive unit 942 includes an actuator.

In one example, the platform 940 is configured to allow for selection of the position of the table 941 relative to the vacuum chamber 910 from a synthesizing position and a standby position.

In one example, the synthesizing position is set so that the distance between the base material, which is arranged on the table 941, and a filament 951 is suitable for diamond synthesis. In one example, the standby position is set so that the distance between the base material and the filament 951 is greater than the distance between the base material and the filament 951 at the synthesizing position.

In one example, the diamond synthesis device 900 includes a heater 950. In one example, the heater 950 heats the raw material gas supplied to the synthesis compartment 911. In one example, the heater 950 includes one or more filaments 951, a holder 952, and a power supply 953.

In one example, the one or more filaments 951 are arranged in the synthesis compartment 911. In one example, each filament 951 includes a first end 951A and a second end 951B.

In one example, the filament 951 is formed of a metal having a high melting point. Examples of a metal having a high melting point include tungsten, tantalum, rhenium, and ruthenium. In one example, the filament 951 includes at least one of tungsten, tantalum, rhenium, and ruthenium.

In one example, the holder 952 is arranged in the vacuum chamber 910. In one example, the holder 952 is configured to allow for attachment and detachment of the one or more filaments 951. In one example, the holder 952 is configured to function as the electrode of the filaments 951.

In one example, the holder 952 includes a first holder 952A and a second holder 952B. In one example, the first holder 952A holds the first end 951A of each filament 951. In one example, the second holder 952B holds the second end 951B of each filament 951.

In one example, the power supply 953 supplies electric power to the one or more filaments 951. In one example, the power supply 953 is electrically connected by a power line 953A to the holder 952. In one example, the power supply 953 is a DC power supply.

Each filament 951 has a diameter referred to as "the filament diameter." In one example, the filament diameter is within a predetermined filament diameter range. In one example, the predetermined filament diameter range is from 0.1 mm to 0.5 mm.

The total pressure of the synthesis compartment 911 is referred to as "the synthesis compartment total pressure." The flow rate of the raw material gas in the supply pump 932 is referred to as "the raw gas flow rate." The temperature of each filament 951 is referred to as "the filament temperature."

In one example, the diamond synthesis device 900 includes a measurement unit 960. In one example, the measurement unit 960 is configured to measure the synthesis compartment total pressure, the raw gas flow rate, and the filament temperature. In one example, the measurement unit 960 includes a sensor that measures the synthesis compartment total pressure, a sensor that measures the raw gas flow rate, and a sensor that measures the filament temperature.

In one example, the diamond synthesis device 900 includes a controller 970. In one example, the controller 970 includes a central processing unit, a main memory, an auxiliary memory, an input unit, and an output unit.

In one example, the controller 970 is configured to control a control subject element. Examples of the control subject element include the vacuum pump 921, the discharge regulation valve 923, the supply regulation valve 933, the drive unit 942, and the power supply 953.

In one example, the controller 970 is configured to perform wired communication or wireless communication with the measurement unit 960. In one example, measurement data including the measurement information of the measurement unit 960 is transmitted to the controller 970. In one example, the controller 970 refers to the measurement data and controls the control subject element.

### Manufacturing Method

In one example, the manufacturing method of the conductive portion 40 includes an arranging step, a gas discharging step, a gas supplying step, and a synthesizing step. The gas discharging step follows the arranging step. The gas supplying step follows the gas discharging step. The synthesizing step follows the gas supplying step.

In one example, the position of the table 941 relative to the vacuum chamber 910 is set to a synthesizing position before the arranging step or after the filament temperature becomes maintained within a predetermined filament temperature range in the synthesizing step.

In the arranging step, the shutter 913 of the vacuum chamber 910 is set in the open state. Then, the base material is arranged on the table 941. Subsequently, the shutter 913 of the vacuum chamber 910 is set in the closed state.

In the gas discharging step, the vacuum pump 921 discharges gas out of the synthesis compartment 911. The discharge of gas decreases the synthesis compartment total pressure. In one example, the synthesis compartment total pressure is maintained within a predetermined discharge state pressure range. Examples of the predetermined discharge state pressure range will now be described.

In a first example, the predetermined discharge state pressure range is a range greater than or equal to a discharge state lower limit pressure. In a second example, the predetermined discharge state pressure range is a range less than or equal to a discharge state upper limit pressure. In a third example, the predetermined discharge state pressure range is a range greater than or equal to the discharge state lower limit pressure and less than or equal to the discharge state upper limit pressure.

In one example, the discharge state lower limit pressure is selected from 0.01 Torr, 0.05 Torr, and 0.1 Torr. In one example, the discharge state upper limit pressure is selected from 0.25 Torr, 0.5 Torr, and 1 Torr.

In the gas supplying step, raw material gas is supplied from the gas tank 931 to the synthesis compartment 911. In one example, the concentration of a carbon source in the raw material gas is within a predetermined carbon source concentration range. Examples of the predetermined carbon source concentration range will now be described.

In a first example, the predetermined carbon source concentration range is a range greater than or equal to a lower limit carbon source concentration. In a second example, the predetermined carbon source concentration range is a range less than or equal to an upper limit carbon source concentration. In a third example, the predetermined carbon source concentration range is greater than or equal to the lower limit carbon source concentration and less than or equal to the upper limit carbon source concentration.

In one example, the lower limit carbon source concentration is selected from 0.1 vol%, 1 vol%, and 3 vol%. In one example, the upper limit carbon source concentration is selected from 4 vol%, 5 vol%, and 6 vol%.

The supply of raw material gas increases the synthesis compartment total pressure. In one example, the synthesis compartment total pressure is maintained within a predetermined supply state pressure range. Examples of the predetermined supply state pressure range will now be described.

In a first example, the predetermined supply state pressure range is a range greater than or equal to a supply state lower limit pressure. In a second example, the predetermined supply state pressure range is a range less than or equal to a supply state upper limit pressure. In a third example, the predetermined supply state pressure range is a range greater than or equal to the supply state lower limit pressure and less than or equal to the supply state upper limit pressure.

In one example, the supply state lower limit pressure is selected from 5 Torr, 10 Torr, and 15 Torr. In one example, the supply state upper limit pressure is selected from 20 Torr, 30 Torr, and 40 Torr.

In one example, the impurity source is included in the raw material gas. The concentration of the impurity source with respect to the carbon source in the raw material gas is referred to as "the impurity source concentration." The concentration of the impurity that is to be included in the impurity layer 44 of the conductive portion 40 is referred to as "the target impurity concentration." In one example, the impurity source concentration is set in accordance with the target impurity concentration.

In one example, the target impurity concentration is within a predetermined impurity concentration range. Examples of the predetermined impurity concentration range will now be described. In a first example, the predetermined impurity concentration range is a range greater than or equal to a lower limit impurity concentration. In a second example, the predetermined impurity concentration range is a range less than or equal to an upper limit impurity concentration. In a third example, the predetermined impurity concentration range is a range greater than or equal to the lower limit impurity concentration and less than or equal to the upper limit impurity concentration.

When boron is included as the impurity in the impurity layer 44, in one example, the lower limit impurity concentration and the upper limit impurity concentration are selected in the following manner.

In one example, the lower limit impurity concentration is selected from 1×10¹⁸ atoms/cm³, 1×10²⁰ atoms/cm³, and 5×10²⁰ atoms/cm³. In one example, the upper limit impurity concentration is selected from 5×10²⁰ atoms/cm³, 5×10²¹ atoms/cm³, and 5×10²² atoms/cm³.

In one example, the impurity source concentration is within a predetermined impurity source concentration range. Examples of the predetermined impurity source concentration range will now be described. In a first example, the predetermined impurity source concentration range is a range greater than or equal to a lower limit impurity source concentration. In a second example, the predetermined impurity source concentration range is a range less than or equal to the upper limit impurity source concentration. In a third example, the predetermined impurity source concentration range is a range greater than or equal to the lower limit impurity source concentration and less than or equal to the upper limit impurity source concentration.

When boron is included as the impurity source in the raw material gas, in one example, the lower limit impurity source concentration and the upper limit impurity source concentration are selected in the following manner.

In one example, the lower limit impurity source concentration is selected from 10 ppm, 50 ppm, and 100 ppm. In one example, the upper limit impurity source concentration is selected from 1000 ppm, 5000 ppm, and 50000 ppm.

In the synthesizing step, each filament 951 is supplied with electric power. The supply of electric power increases the filament temperature. In one example, the filament temperature is maintained within a predetermined filament temperature range. Examples of the predetermined filament temperature range will now be described.

In a first example, the predetermined filament temperature range is a range greater than or equal to a lower limit filament temperature. In a second example, the predetermined filament temperature range is a range less than or equal to an upper limit filament temperature. In a third example, the predetermined filament temperature range is a range greater than or equal to the lower limit filament temperature and less than or equal to the upper limit filament temperature.

In one example, the lower limit filament temperature is selected from 2000 °C, 2100 °C, and 2200 °C. In one example, the upper limit filament temperature is selected from 2300 °C, 2500 °C, and 3000 °C.

In one example, the predetermined filament temperature range is set according to the relationship with a synthesis affecting factor that affects synthesis of the conductive portion 40. Examples of the synthesis affecting factor include the type of metal element forming the filament 951, the concentration of the metal element included in the conductive portion 40, and the concentration of the impurity included in the conductive portion 40.

The temperature of the base material is referred to as "the base material temperature." The heating of the filaments 951 increases the base material temperature. In one example, the base material temperature is maintained within a predetermined base material temperature range.

Examples of the predetermined base material temperature range will now be described. In a first example, the predetermined base material temperature range is a range greater than or equal to a lower limit base material temperature. In a second example, the predetermined base material temperature range is a range less than or equal to the upper limit base material temperature. In a third example, the predetermined base material temperature range is a range greater than or equal to the lower limit base material temperature and less than or equal to the upper limit base material temperature.

In one example, the lower limit base material temperature is selected from 600 °C, 700 °C, and 800 °C. In one example, the upper limit base material temperature is selected from 900 °C, 1100 °C, and 1200 °C.

### Second Embodiment

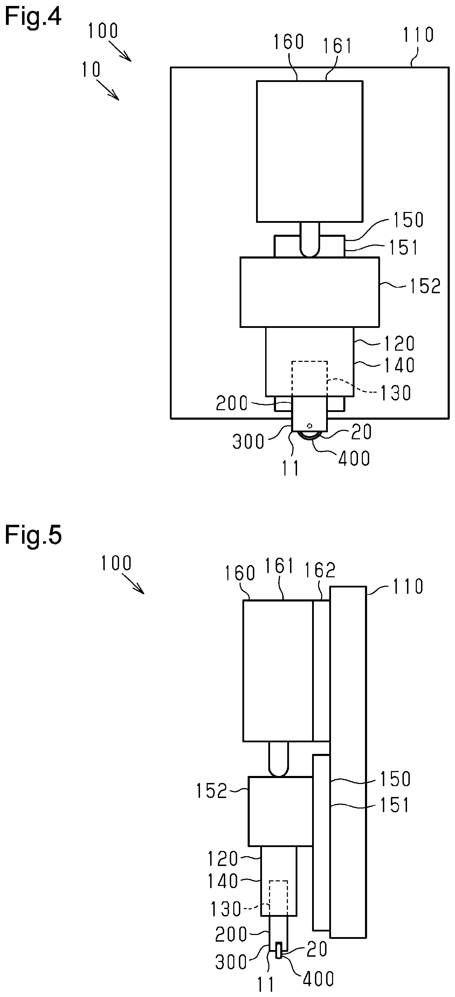

Reference will be made to Figs. 4 to 8. The tool unit 10 and the diamond tool 20 in accordance with the present embodiment are based on the first embodiment. The tool unit 10 and the diamond tool 20 in accordance with the present embodiment include elements that are the same as the above embodiment.

Some or all of the elements of the tool unit 10 and the diamond tool 20 in the present embodiment that are the same as the elements of the tool unit 10 and the diamond tool 20 in accordance with the above embodiment will not be described.

The machining device of the present embodiment is a scriber. The tool unit 10 in the present embodiment is a holder unit 200. The tool support 11 in the present embodiment is a wheel holder 300. The diamond tool 20 in the present embodiment is a scribing wheel 400.

### Scriber

The scriber may have any structure. The scriber is not limited to the exemplified structure.

In one example, the scriber is configured to scribe a workpiece. One example of the workpiece is a substrate. One example of a substrate is a brittle material substrate.

Examples of a brittle material substrate include a compound semiconductor substrate, a ceramic substrate, a glass substrate, a silicon substrate, a sapphire substrate, and a quartz substrate.

Examples of a compound semiconductor substrate include a silicon carbide substrate, a gallium nitride substrate, a gallium oxide substrate, an indium phosphide substrate, and a gallium arsenide substrate. One example of a ceramic substrate is an alumina substrate.

In one example, the scriber includes a table, a scribe head 100, a moving device, etc. In one example, the table includes a setting surface on which the workpiece is set. In one example, the scribe head 100 is attached to the moving device.

In one example, the moving device is configured to move the scribe head 100 relative to the workpiece to any position. In one example, the moving device includes at least one of a planar moving unit and a vertical moving unit.

In one example, the planar moving unit changes the position of the scribe head 100 in a direction parallel to the setting surface of the table. In one example, the vertical moving unit changes the position of the scribe head 100 in a direction orthogonal to the setting surface of the table.

### Scribe Head

Reference will be made to Figs. 4 and 5. The scribe head 100 may have any structure. The scribe head 100 is not limited to the exemplified structure.

In one example, the scribe head 100 includes a mount 110. In one example, the mount 110 is attached to the moving device. An example of the mount 110 and the moving device will now be described. In a first example, the mount 110 is attached to the planar moving unit of the moving device. In a second example, the mount 110 is attached to the vertical moving unit.

In one example, the scribe head 100 includes a holder assembly 120. In one example, the holder assembly 120 includes the holder unit 200. In one example, the holder unit 200 includes the wheel holder 300 and the scribing wheel 400.

In one example, the wheel holder 300 supports the scribing wheel 400 in a manner rotatable to the wheel holder 300. In one example, the scribing wheel 400 is configured to scribe a workpiece.

In one example, the holder assembly 120 includes a holder joint 130. In one example, the holder joint 130 is configured to support the holder unit 200. An example of the holder joint 130 and the holder unit 200 will now be described.

In a first example, the holder unit 200 is configured to allow for attachment and detachment of the holder joint 130. In a second example, the holder unit 200 is formed integrally with the holder joint 130.

In one example, the scribe head 100 includes a holder joint retainer 140. In one example, the holder joint retainer 140 is configured to support the holder assembly 120. In one example, the holder joint 130 is coupled to the holder joint retainer 140.

An example of the holder joint 130 and the holder joint retainer 140 will now be described. In a first example, the holder joint 130 is configured to allow for attachment and detachment of the holder joint retainer 140. In a second example, the holder joint 130 is formed integrally with the holder joint retainer 140.

In one example, the scribe head 100 includes a coupling portion 150. In one example, the coupling portion 150 is configured to couple the holder joint retainer 140 to the mount 110. An example of the coupling portion 150 will now be described.

In a first example, the coupling portion 150 couples the holder joint retainer 140 to the mount 110 in a manner allowing for movement of the holder joint retainer 140 in a predetermined direction relative to the mount 110. In one example, the predetermined direction includes a direction orthogonal to the setting surface of the table and a direction orthogonal to the setting surface of the table.

In a second example, the coupling portion 150 couples the holder joint retainer 140 to the mount 110 in a manner restricting movement of the holder joint retainer 140 relative to the mount 110.

In one example, the coupling portion 150 includes a rail 151 and a slider 152. In one example, the coupling portion 150 is configured to move the holder joint retainer 140 relative to the mount 110 in a direction orthogonal to the setting surface of the table.

In one example, the rail 151 is arranged on one of the mount 110 and the holder joint retainer 140. In one example, the slider 152 is arranged on the other one of the mount 110 and the holder joint retainer 140.

In one example, the scribe head 100 includes a load adjustment unit 160. In one example, the load adjustment unit 160 adjusts the force that presses the scribing wheel 400 against the workpiece. In one example, the load adjustment unit 160 includes an actuator 161 and a bracket 162.

In one example, the actuator 161 is coupled to the bracket 162. In one example, the bracket 162 is coupled to the mount 110.

In one example, the actuator 161 presses the holder joint retainer 140, the rail 151 coupled to the holder joint retainer 140, or the slider 152 coupled to the holder joint retainer 140 against the workpiece.

Examples of the actuator 161 include a power cylinder, a solenoid, an electric motor, a servo motor, a linear actuator, etc. Examples of the power cylinder include a hydraulic cylinder, a pneumatic cylinder, a water-hydraulic cylinder, and an electric cylinder.

### Holder Unit

Reference will be made to Figs. 4, 5, and 8. The holder unit 200 may have any structure. The holder unit 200 is not limited to the exemplified structure.

In one example, the holder unit 200 is supported by the holder joint 130 in a manner rotatable about the center axis of the holder joint 130 relative to the holder joint retainer 140.

In one example, the holder unit 200 includes a pin 210. In one example, the pin 210 is formed from a material having a high hardness. Examples of a high-hardness material include a single-crystal diamond, a polycrystalline diamond, and cemented carbide.

In one example, the pin 210 is supported by the wheel holder 300 in a manner rotatable to the wheel holder 300.

In one example, the pin 210 supports the scribing wheel 400 in a manner rotatable relative to the pin 210 about the center axis of the pin 210.

In one example, the pin 210 supports the scribing wheel 400 in a manner movable relative to the pin 210 in a direction parallel to the center axis of the pin 210.

### Scribing Wheel

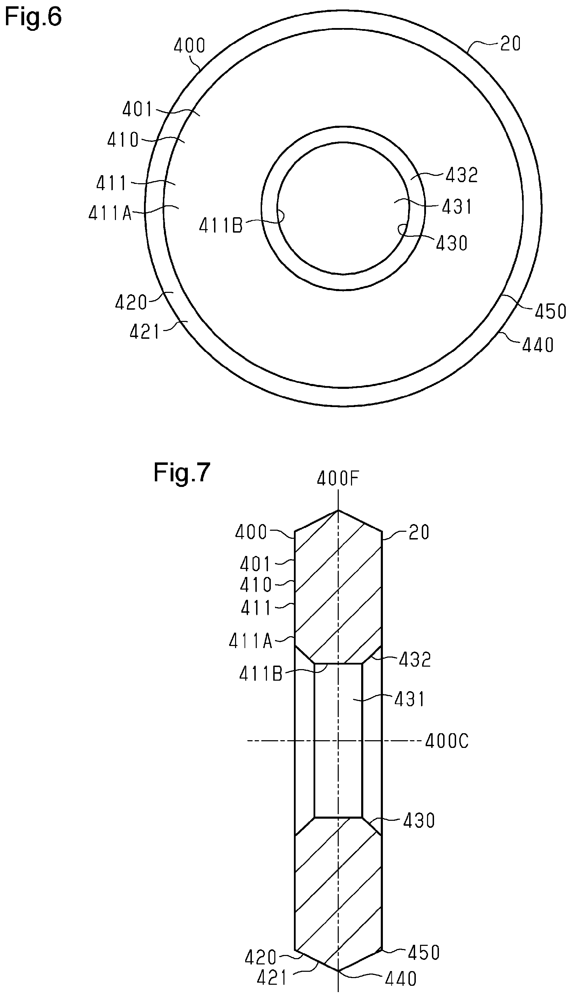

Reference will be made to Figs. 6 and 7. The scribing wheel 400 may have any structure. The scribing wheel 400 is not limited to the exemplified structure.

The scribing wheel 400 has a center axis referred to as "the wheel center axis 400C." The scribing wheel 400 has a center plane referred to as "the wheel center plane 400F." In one example, the wheel center plane 400F passes through the center of the scribing wheel 400 with respect to the axial direction of the scribing wheel 400, and is orthogonal to the wheel center axis 400C.

In one example, the scribing wheel 400 is shaped to be symmetric or asymmetric with respect to the wheel center plane 400F.

In one example, the scribing wheel 400 is divided into an inner circumferential portion 410 and an outer circumferential portion 420 in the radial direction of the scribing wheel 400.

In one example, the inner circumferential portion 410 is arranged around the wheel center axis 400C in the radial direction of the scribing wheel 400.

In one example, the outer circumferential portion 420 is arranged at the outer side of the inner circumferential portion 410 in the radial direction of the scribing wheel 400. In one example, the outer circumferential portion 420 has a thickness that decreases toward the outer side in the radial direction of the scribing wheel 400.

In one example, the inner circumferential portion 410 includes a through portion 430. In one example, the through portion 430 is configured to allow the pin 210 to be arranged therein.

In one example, the through portion 430 includes a hole 431. In one example, the hole 431 extends through the inner circumferential portion 410 in the axial direction of the scribing wheel 400.

In one example, the through portion 430 includes chamfers 432. In one example, the chamfers 432 are formed around the hole 431.

In one example, the outer circumferential portion 420 includes a blade edge 440 that scribes a workpiece. In one example, the blade edge 440 is located at the distal end of the outer circumferential portion 420 in the radial direction of the scribing wheel 400.

The scribing wheel 400 has a surface referred to as "the wheel surface 401." The inner circumferential portion 410 has a surface referred to as "the inner circumferential portion surface 411." The outer circumferential portion 420 has a surface referred to as "the outer circumferential portion surface 421." In one example, the wheel surface 401 includes the inner circumferential portion surface 411 and the outer circumferential portion surface 421.

In one example, the inner circumferential portion surface 411 includes a side surface 411A. In one example, the side surface 411A is a base plane. In one example, the side surface 411A is parallel to the wheel center plane 400F.

In one example, the inner circumferential portion surface 411 includes a curved surface 411B. In one example, the curved surface 411B defines the hole 431. In one example, the curved surface 411B contacts the pin 210.

In one example, the outer circumferential portion surface 421 is an inclined surface. In one example, the outer circumferential portion surface 421 is inclined relative to the wheel center plane 400F.

In one example, the scribing wheel 400 includes a boundary 450. In one example, the boundary 450 is an edge or a portion corresponding to the edge formed between the side surface 411A of the inner circumferential portion surface 411 and the outer circumferential portion surface 421.

### Base and Conductive Portion

Reference will be made to Figs. 2, 6, and 7. In one example, the base 30 forms the main body of the scribing wheel 400. In one example, the base 30 is divided into the inner circumferential portion 410 and the outer circumferential portion 420.

In one example, the conductive portion 40 is formed on at least one of the inner circumferential portion 410 and the outer circumferential portion 420 of the base 30. In the example in which the conductive portion 40 is formed on at least one of the inner circumferential portion 410 and the outer circumferential portion 420 of the base 30, the conductive portion 40 is divided into the inner circumferential portion 410 and the outer circumferential portion 420. An example of the structure of the conductive portion 40 (hereafter referred to as "the conductive portion structure") in the range where the base 30 is formed will now be described.

In a first example, the conductive portion 40 is formed on the entire inner circumferential portion 410 of the base 30 and on the entire outer circumferential portion 420 of the base 30. The inner circumferential portion 410 includes the base 30 and the conductive portion 40. The outer circumferential portion 420 includes the base 30 and the conductive portion 40.

In a second example, the conductive portion 40 is formed on part of the inner circumferential portion 410 of the base 30 and on the entire outer circumferential portion 420 of the base 30. The inner circumferential portion 410 includes the base 30 and the conductive portion 40. The outer circumferential portion 420 includes the base 30 and the conductive portion 40.

In a third example, the conductive portion 40 is formed on the entire inner circumferential portion 410 of the base 30 and on part of the outer circumferential portion 420 of the base 30. The inner circumferential portion 410 includes the base 30 and the conductive portion 40. The outer circumferential portion 420 includes the base 30 and the conductive portion 40.

In a fourth example, the conductive portion 40 is formed on part of the inner circumferential portion 410 of the base 30 and on part of the outer circumferential portion 420 of the base 30. The inner circumferential portion 410 includes the base 30 and the conductive portion 40. The outer circumferential portion 420 includes the base 30 and the conductive portion 40.

In a fifth example, the conductive portion 40 is formed on the entire inner circumferential portion 410 of the base 30. The conductive portion 40 is not formed on the outer circumferential portion 420 of the base 30. The inner circumferential portion 410 includes the base 30 and the conductive portion 40. The outer circumferential portion 420 includes the base 30.

In a sixth example, the conductive portion 40 is formed on part of the inner circumferential portion 410 of the base 30. The conductive portion 40 is not formed on the outer circumferential portion 420 of the base 30. The inner circumferential portion 410 includes the base 30 and the conductive portion 40. The outer circumferential portion 420 includes the base 30.

In a seventh example, the conductive portion 40 is not formed on the inner circumferential portion 410 of the base 30. The conductive portion 40 is formed on the entire outer circumferential portion 420 of the base 30. The inner circumferential portion 410 includes the base 30. The outer circumferential portion 420 includes the base 30 and the conductive portion 40.

In an eighth example, the conductive portion 40 is not formed on the inner circumferential portion 410 of the base 30. The conductive portion 40 is formed on part of the outer circumferential portion 420 of the base 30. The inner circumferential portion 410 includes the base 30. The outer circumferential portion 420 includes the base 30 and the conductive portion 40.

In the structures of the second to eighth examples related to the conductive portion structure, the wheel surface 401 includes the base surface 31 and the conductive portion surface 41. The wheel surface 401 includes the base surface 31, which is electrically insulating, and the conductive portion surface 41, which is electrically conductive.

In the second example related to the conductive portion structure, part of the inner circumferential portion surface 411 in the base surface 31 forms the wheel surface 401.

In the third example related to the conductive portion structure, part of the outer circumferential portion surface 421 in the base surface 31 forms the wheel surface 401.

In the fourth example related to the conductive portion structure, part of the inner circumferential portion surface 411 in the base surface 31 and part of the outer circumferential portion surface 421 in the base surface 31 form the wheel surface 401.

In the fifth example related to the conductive portion structure, the entire outer circumferential portion surface 421 in the base surface 31 forms the wheel surface 401.

In the sixth example related to the conductive portion structure, part of the inner circumferential portion surface 411 in the base surface 31 and the entire outer circumferential portion surface 421 in the base surface 31 form the wheel surface 401.

In the seventh example related to the conductive portion structure, the entire inner circumferential portion surface 411 in the base surface 31 forms the wheel surface 401.

In the eighth example related to the conductive portion structure, the entire inner circumferential portion surface 411 in the base surface 31 and part of the outer circumferential portion surface 421 in the base surface 31 form the wheel surface 401.

In one example, the base 30 is formed by only an electrical insulator or by an electrical insulator and an electrical conductor. In one example, the electrical insulator forming the base 30 is the single-crystal portion 32, which is electrically insulating. An example of the structure of the base 30 (hereafter referred to as "the base structure") in relation to electrical properties will now be described.

In a first example, the interior of the inner circumferential portion 410 of the base 30 is formed by only an electrical insulator. The interior of the inner circumferential portion 410 of the base 30 is not formed by an electrical conductor. The interior of the outer circumferential portion 420 of the base 30 is formed by only an electrical insulator. The interior of the outer circumferential portion 420 of the base 30 is not formed by an electrical conductor.

In a second example, the interior of the inner circumferential portion 410 of the base 30 is formed by an electrical insulator and an electrical conductor. The interior of the outer circumferential portion 420 of the base 30 is formed by only an electrical insulator. The interior of the outer circumferential portion 420 of the base 30 is not formed by an electrical conductor.

In a third example, the inner circumferential portion 410 of the base 30 is formed by only an electrical insulator. The interior of the inner circumferential portion 410 of the base 30 is not formed by an electrical conductor. The interior of the outer circumferential portion 420 of the base 30 is formed by an electrical insulator and an electrical conductor.

In a fourth example, the interior of the inner circumferential portion 410 of the base 30 is formed by an electrical insulator and an electrical conductor. The interior of the outer circumferential portion 420 of the base 30 is formed by an electrical insulator and an electrical conductor.

As long as there is technical consistency, the structures of the first to fourth examples related to the base structure may be combined with the first to eighth examples related the conductive portion structure.

### Wheel Holder

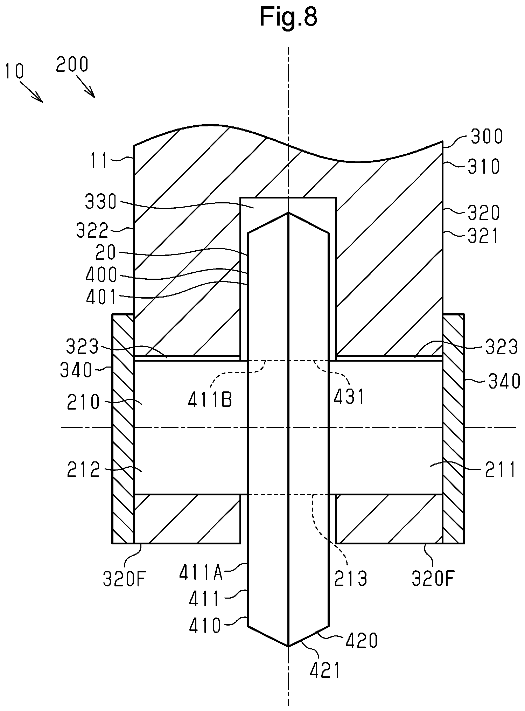

Reference will be made to Fig. 8. The wheel holder 300 may have any structure. The wheel holder 300 is not limited to the exemplified structure.

In one example, a lateral direction, a vertical direction, and a longitudinal direction are defined for the wheel holder 300. The lateral direction of the wheel holder 300 is parallel to the X-axis. The vertical direction of the wheel holder 300 is parallel to the Z-axis. The longitudinal direction of the wheel holder 300 is parallel to the Y-axis.

The left-right direction in Fig. 8 is parallel to the X-axis. The up-down direction in Fig. 8 is parallel to the Z-axis. The direction orthogonal to the plane of Fig. 8 is parallel to the Y-axis.

In one example, the wheel holder 300 includes a holder body 310. In one example, the holder body 310 is coupled to the holder joint 130. An example of the holder joint 130 and the holder body 310 will now be described.

In a first example, the holder body 310 is configured to allow for attachment to and detachment from the holder joint 130. In a second example, the holder body 310 is formed integrally with the holder joint 130.

In one example, the wheel holder 300 includes a pin support 320. In one example, the pin support 320 is located downward from the holder body 310 in the vertical direction of the wheel holder 300.

In one example, the pin support 320 includes a bottom surface 320F. In one example, the bottom surface 320F faces the workpiece. In one example, when the scribing wheel 400 is in contact with the workpiece, space extends between the bottom surface 320F and the workpiece.

In one example, the pin support 320 includes a first pin support 321 and a second pin support 322. In one example, the pin supports 321 and 322 are spaced apart from each other in the lateral direction of the wheel holder 300.

In one example, the wheel holder 300 includes a wheel receptacle 330. In one example, the wheel receptacle 330 extends between the first pin support 321 and the second pin support 322 in the lateral direction of the wheel holder 300. In one example, the wheel receptacle 330 allows for the arrangement of the scribing wheel 400 therein.

In one example, a slight gap extends between the side surface 411A of the scribing wheel 400 and the first pin support 321 in the lateral direction of the wheel holder 300.

In one example, movement of the scribing wheel 400 relative to the pin 210 in a direction parallel to the center axis of the pin 210 may cause the side surface 411A of the scribing wheel 400 to come into contact with the first pin support 321.

In one example, a slight gap extends between the side surface 411A of the scribing wheel 400 and the second pin support 322 in the lateral direction of the wheel holder 300.

In one example, movement of the scribing wheel 400 relative to the pin 210 in a direction parallel to the center axis of the pin 210 may cause the side surface 411A of the scribing wheel 400 to come into contact with the second pin support 322.

In one example, the pin supports 321 and 322 each include a pin receptacle 323. In one example, the pin receptacle 323 includes a hole extending through the corresponding one of the pin supports 321 and 322. In one example, the pin receptacle 323 allows for arrangement of the pin 210 therein.

In one example, the pin 210 has a cylindrical shape. In one example, the pin 210 includes a first end 211, a second end 212, and an intermediate portion 213.

In one example, the first end 211 is arranged in the pin receptacle 323 of the first pin support 321. In one example, the second end 212 of the pin 210 is arranged in the pin receptacle 323 of the second pin support 322.

In one example, the intermediate portion 213 is located between the first end 211 and the second end 212 in a direction parallel to the center axis of the pin 210. In one example, the intermediate portion 213 is arranged in the hole 431 of the scribing wheel 400.

In one example, the wheel holder 300 includes stoppers 340. In one example, the stoppers 340 close the openings of the pin receptacles 323 so that the pin 210 does not move out of the pin support 320.

### Advantages

Examples of advantages of the tool unit 10 or the diamond tool 20 will now be described.

In one example, the diamond tool 20 includes the base 30, which includes the single-crystal portion 32 formed by single-crystal diamond, and the conductive portion 40, which is formed on the single-crystal portion 32. The conductive portion 40 includes the conductive portion surface 41, which forms the tool surface 21. The base 30 is formed by only the single-crystal portion 32, which is electrically insulating.

The above structure has, for example, the following advantage. The tool surface 21 is electrically conductive. Thus, the tool surface 21 resists electrical charging. This reduces the cutting chips that collect on the tool surface 21.

The above structure further has, for example, the following advantage. The deposition of machining chips is reduced between the tool surface 21 and the workpiece. This maintains the machining performance of the diamond tool 20.

The above structure further has, for example, the following advantage. The base 30 is formed by only the single-crystal portion 32. This allows the base 30 to be formed from an inexpensive single-crystal diamond.

In one example, the conductive portion 40 includes the hydrogen-terminated diamond 42.

The above structure has, for example, the following advantage. The conductive portion 40 includes the hydrogen-terminated diamond 42 that increases the electrical conductivity of the conductive portion 40.

In one example, the base 30 includes the hydrogen-terminated layer 43 and the impurity layer 44. The impurity layer 44 is formed on the single-crystal portion 32. The hydrogen-terminated layer 43 is formed on the impurity layer 44. The hydrogen-terminated layer 43 includes the hydrogen-terminated diamond 42.

The above structure has, for example, the following advantage. The conductive portion 40 includes the hydrogen-terminated layer 43 and the impurity layer 44. This increases the electrical conductivity of the conductive portion 40.

In one example, the conductive portion surface 41 of the conductive portion 40 forms the entire tool surface 21.

The above structure has, for example, the following advantage. The cutting chips that collect on the tool surface 21 are reduced.

In one example, the conductive portion resistivity is less than or equal to the upper limit conductive portion resistivity.

The above structure has, for example, the following advantage. The conductive portion 40 is resistant to electrical charging. The tool surface 21 is resistant to electrical charging.

In one example, the thickness of the conductive portion 40 is less than or equal to the upper limit conductive portion thickness.

The above structure has, for example, the following advantage. The base surface 31 of the diamond tool 20 in the base state has a shape similar to the shape of the conductive portion surface 41. This maintains the machining performance of the diamond tool 20 when, for example, the conductive portion 40 is synthesized.

The above structure further has, for example, the following advantage. The time for synthesizing the conductive portion 40 is shortened.

In one example, the diamond tool 20 is the scribing wheel 400.

The above structure has, for example, the following advantage. When scribing a workpiece with the scribing wheel 400, the cutting chips that collect on the scribing wheel 400 are reduced.

The above structure further has, for example, the following advantage. The quality and accuracy for machining a workpiece is improved. The life of the scribing wheel 400 is prolonged.

In one example, the tool unit 10 includes the diamond tool 20 and the tool support 11, which supports the diamond tool 20.

The above structure has, for example, the following advantage. The tool surface 21 is resistant to electrical charging. The cutting chips that collect on the tool surface 21 are reduced. The cutting chips that remain between the diamond tool 20 and the tool support 11 are reduced.

The above structure further has, for example, the following advantage. The cutting chips that collect on the tool support 11 are reduced.

The above structure further has, for example, the following advantage. The quality and accuracy for machining a workpiece is improved. The life of the scribing wheel 400 is prolonged.

### Advantage 2

Examples of advantages of the tool unit 10 or the diamond tool 20 will now be described.

In one example, the base surface 31 is formed by the single-crystal portion 32. The conductive portion 40 is formed on the base surface 31.

The above structure has, for example, the following advantage. The roughness of the conductive portion surface 41 is reduced.

In one example, thickness of the conductive portion 40 is greater than or equal to the lower limit conductive portion thickness.

The above structure has, for example, the following advantage. The conductive portion 40 is readily formed having electrical conductivity that limits electrical charging of the tool surface 21.

The above structure further has, for example, the following advantage. Even when the conductive portion surface 41 wears, the tool surface 21 will continue to be readily formed by the conductive portion surface 41.

In one example, the hydrogen-terminated layer thickness is greater than or equal to the lower limit hydrogen-terminated layer thickness.

The above structure has, for example, the following advantage. The hydrogen-terminated layer 43 is readily formed having electrical conductivity that limits electrical charging of the tool surface 21.

The above structure further has, for example, the following advantage. Even when the conductive portion surface 41 wears, the tool surface 21 will continue to be readily formed by the conductive portion surface 41.

In one example, the hydrogen-terminated layer thickness is less than or equal to the upper limit hydrogen-terminated layer thickness.

The above structure has, for example, the following advantage. The base surface 31 of the diamond tool 20 in the base state has a shape similar to the shape of the conductive portion surface 41. This maintains the machining performance of the diamond tool 20 when, for example, the conductive portion 40 is synthesized.

The above structure further has, for example, the following advantage. The time for synthesizing the conductive portion 40 is shortened.

In one example, the impurity layer thickness is greater than or equal to the lower limit impurity layer thickness.

The above structure has, for example, the following advantage. The impurity layer 44 is readily formed having electrical conductivity that limits electrical charging of the tool surface 21.

The above structure further has, for example, the following advantage. Even when the conductive portion surface 41 wears, the tool surface 21 will continue to be readily formed by the conductive portion surface 41.

In one example, the impurity layer thickness is less than or equal to the upper limit impurity layer thickness.

The above structure has, for example, the following advantage. The base surface 31 of the diamond tool 20 in the base state has a shape similar to the shape of the conductive portion surface 41. This maintains the machining performance of the diamond tool 20 when, for example, the conductive portion 40 is synthesized.

The above structure further has, for example, the following advantage. The time for synthesizing the conductive portion 40 is shortened.

In one example, the concentration of a carbon source in the raw material gas is within a predetermined carbon source concentration range.

The above structure has, for example, the following advantage. The conductive portion 40 is readily synthesized in a proper manner.

In one example, the impurity source concentration is within the predetermined impurity source concentration range.

The above structure has, for example, the following advantage. The impurity layer 44 is readily synthesized in a proper manner.

In one example, the filament temperature is maintained within the predetermined filament temperature range.

The above structure has, for example, the following advantage. The conductive portion 40 is readily synthesized in a proper manner.

### Advantage 3

Examples of advantages of the holder unit 200 or the scribing wheel 400 will now be described.

In one example, the conductive portion surface 41 of the conductive portion 40 forms a part of or an entirety of the wheel surface 401.

The above structure has, for example, the following advantage. The cutting chips that collect on the wheel surface 401 are reduced. The deposition of machining chips is reduced between the wheel surface 401 and the wheel holder 300.

The above structure further has, for example, the following advantage. The rotational characteristics of the scribing wheel 400 are improved.

The above structure further has, for example, the following advantage. The quality and accuracy for machining a workpiece is improved. The life of the scribing wheel 400 is prolonged.

The above structure further has, for example, the following advantage. The coefficient of friction related to the frictional force produced between the scribing wheel 400 and the workpiece is selected as one example of an index related to the rotational characteristics of the scribing wheel 400.

When the scribing device performs scribing, as the distance over which the scribing wheel 400 travels on the workpiece increases, increases in the coefficient of friction will become smaller. In one example, when the distance over which the scribing wheel 400 travels on the workpiece is less than or equal to a predetermined distance, the coefficient of friction will not increase.

The above structure further has, for example, the following advantage. The cullets that collect on the bottom surface 320F of the pin support 320 are reduced.

In one example, the conductive portion surface 41 of the scribing wheel 400 forms a part of or an entirety of the inner circumferential portion surface 411.

The above structure has, for example, the following advantage. The cutting chips that collect on the inner circumferential portion surface 411 are reduced. The deposition of machining chips is reduced between the inner circumferential portion surface 411 and the pin support 320.

The above structure further has, for example, the following advantage. The rotational characteristics of the scribing wheel 400 is improved.

The above structure further has, for example, the following advantage. The quality and accuracy for machining a workpiece is improved. The life of the scribing wheel 400 is prolonged.

In one example, the conductive portion surface 41 of the scribing wheel 400 forms a part of or an entirety of the curved surface 411B of the inner circumferential portion surface 411, which defines the hole 431 of the through portion 430.

The above structure has, for example, the following advantage. The cutting chips that collect on the curved surface 411B of the inner circumferential portion surface 411 are reduced. The deposition of machining chips is reduced between the curved surface 411B and the pin 210.

The above structure further has, for example, the following advantage. The rotational characteristics of the scribing wheel 400 is improved.

The above structure further has, for example, the following advantage. The quality and accuracy for machining a workpiece is improved. The life of the scribing wheel 400 is prolonged.

The forms of the diamond tool and the tool unit in accordance with the present invention are not limited to those described in the embodiments. The diamond tool and tool unit in accordance with the present invention may take forms that differ from the forms exemplified in the embodiments. For example, the structure in the embodiments may be replaced, changed, or omitted in part or include an additional element.

### REFERENCE SIGNS LIST

10) tool unit
11) tool support
20) diamond tool
30) base
32) single-crystal portion
40) conductive portion
41) conductive portion surface
42) hydrogen-terminated diamond
43) hydrogen-terminated layer
44) impurity layer
400) scribing wheel

## Claims

1. A diamond tool, comprising:
a base including a single-crystal portion formed by a single-crystal diamond; and
a conductive portion formed on the single-crystal portion, wherein
the conductive portion includes a conductive portion surface forming a surface of the diamond tool, and
the base is formed by only the single-crystal portion that is electrically insulating.

2. The diamond tool according to claim 1, wherein the conductive portion surface includes hydrogen-terminated diamond.

3. The diamond tool according to claim 2, wherein
the conductive portion includes a hydrogen-terminated layer and an impurity layer,
the impurity layer is formed on the single-crystal portion, and
the hydrogen-terminated layer is formed on the impurity layer and includes the hydrogen-terminated diamond.

4. The diamond tool according to claim 3, wherein the conductive portion surface forms an entirety of the surface of the diamond tool.

5. The diamond tool according to claim 1, wherein the conductive portion has an electrical resistivity of 10 Ω cm or less.

6. The diamond tool according to claim 1, wherein the conductive portion has a thickness of 2000 nm or less.

7. The diamond tool according to any one of claims 1 to 6, wherein the diamond tool is a scribing wheel.

8. A tool unit, comprising:
the diamond tool according to any one of claims 1 to 6; and
a tool support supporting the diamond tool.
